Europäisches Patentamt

European Patent Office

Office européen des brevets

(11) Publication number: 0 363 093 A2

# EUROPEAN PATENT APPLICATION

(21) Application number: 89309959.8

(22) Date of filing: 29.09.89

(51) Int. Cl.5: C23C 14/20 , C23C 14/34 , G02B 1/10

(30) Priority: 06.10.88 US 254448

(43) Date of publication of application:
11.04.90 Bulletin 90/15

(84) Designated Contracting States:
BE DE ES FR GB IT NL SE

(71) Applicant: MINNESOTA MINING AND MANUFACTURING COMPANY
3M Center, P.O. Box 33427
Saint Paul, MN 55133- 3427(US)

(72) Inventor: McClure, Donald J. c/o Minnesota Mining and
Manufacturing Company 2501 Hudson Road
St. Paul Minnesota 55144-1000(US)

(74) Representative: Baillie, Iain Cameron et al
c/o Ladas & Parry Isartorplatz 5
D-8000 München 2(DE)

(54) Surface priming of polycarbonate substrates.

(57) A process for treating the surface of a polycarbonate substrate to increase adherence of a subsequently applied reflective metal layer which includes sputtering a primer metal upon the surface. A process for forming a reflector by sputtering a primer metal upon a polycarbonate substrate followed by depositing a layer of reflective metal. A reflector including a sputter primed polycarbonate article and an adherent reflector metal.

FIG.1

# SURFACE PRIMING OF POLYCARBONATE SUBSTRATES

The present invention relates to improving the adherence of metal layers upon polyoarbonate articles and more specifically to priming of polycarbonate articles.

## BACKGROUND OF THE INVENTION

Reflectors and mirrors have been known since antiquity. In the past they were usually made by coating a glass substrate with silver. In these traditional reflectors the silver contributed high efficiency of light reflection and the glass substrate provided rigidity. In more recent times, vacuum-evaporated coatings of aluminum on highly polished substrate surfaces have become the accepted standard for quality mirrors. Mirror configurations can be either front or back surfaced. Back surfaced mirrors are typically used where the metallic reflecting layer is to be completely protected behind a glass substrate.

Desirable alternative materials for reflector substrates are also very rigid yet allow reduced weight, increased strength, shatter resistance, and/or greater economy than glass.

One potentially useful family of alternative substrate materials are the polycarbonate polymers. These light transmitting polymers are readily fabricated into desirable complex shapes. However, the usefulness of polycarbonates as reflector substrates. is presently limited by inadequate adherence of evaporated aluminum coatings.

## SUMMARY OF THE INVENTION

We have surprisingly discovered that the inadequate adherence of evaporated aluminum coatings to polycarbonate substrates, particularly polycarbonate substrates including mold release agents, is dramatically strengthened by sputter priming of the substrate prior to deposition of evaporated aluminum coatings.

The present invention includes a process for treating the surface of a polycarbonate substrate to increase adherence of a subsequently applied reflective metal layer. The process includes sputtering of a primer metal upon the surface of the polycarbonate. The present invention also includes a process for forming a reflector. The process includes providing a polycarbonate substrate having a desired surface shape or structure, sputtering a primer metal upon the surface and depositing of a layer of reflective metal upon the sputter primed surface.

The present invention also includes a polycarbonate substrate having a sputtered primed surface; a sputtered primed polycarbonate substrate with a reflective metal layer upon the sputtered primed surface; and a polycarbonate substrate with a sputtered primed surface having a reflective metal upon the sputtered primed surface and an adhesive layer upon the reflector metal.

## BRIEF DESCRIPTION OF THE DRAWINGS

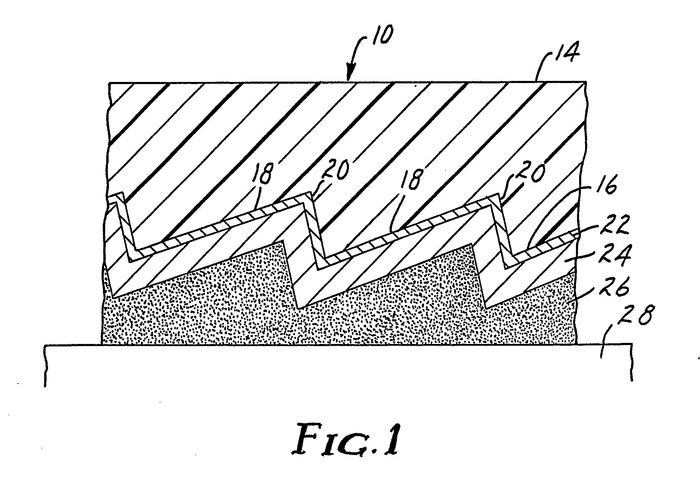

Figure 1 is a schematic cross-sectional view of a portion of a structured, primed surface of a polycarbonate substrate including a reflector layer and an adhesive layer according to these invention.

## DETAILED DESCRIPTION OF THE PREFERRED EMBODIMENTS

The subject invention includes a process for treating the surface of a polycarbonate substrate to increase adherence of a subsequently applied reflective metal layer. The process includes the step of sputtering a primer metal upon the surface or face of the polycarbonate substrate or article. Effective primer metals are generally those metals which when sputtered upon a polycarbonate surface result in a more strongly adhering reflective metal layer. Examples of primer metals are titanium and copper. In a most preferred embodiment, the primer metal is titanium.

Effective sputtering of titanium occurs at pressures from about $10^{-5}$ to about $10^{-1}$ torr and is

dependent on the sputtering procedure employed. For D.C. magnetron sputtering, pressures should be about $2 \times 10^{-3}$ to about $1 \times 10^{-1}$ torr. Preferably, the pressure is from about $2.7 \times 10^{-3}$ to about $4.3 \times 10^{-3}$ torr for D.C. magnetron sputtering. Effective compositions of the sputtering atmosphere depend upon the priming metal being employed. For example, when the priming metal is titanium, the sputtering atmosphere may include argon or other inert gases, oxygen, air or nitrogen. When copper is employed as a priming metal, the composition of the sputtering atmosphere should be oxygen. Sputtering of copper in an argon atmosphere was ineffective to promote adhesion. Suitable voltage applied to the sputtering apparatus is dependent upon the sputtering technique employed. For D.C. magnetron sputtering, the voltage is dependent upon the magnetic field, with voltages in the range of about 360 to about 470 volts being preferred.

In reactive sputtering atmospheres, such as those atmospheres including oxygen or nitrogen, the sputtered primer metal may be chemically combined or reacted to form a sputter metal containing compound. For example, titanium suboxide or titanium nitride might be deposited upon the substrate. For the purposes of this application, the term "sputtered primer metal" includes any compounds so formed.

In the case of titanium priming metal, the average thicknesses deposited upon the polycarbonate substrate range from about 0.5 to about 7 nm. By "average thickness" in this application is meant that thickness of primer metal equivalent to the deposited metal mass on a unit area of substrate surface.

Thus far, however, an ineffective thickness of titanium (or titanium containing material) has not been observed, so that the effective range of thickness may be much broader.

Alternatively, the amount of primer metal deposited may be described as ranging from about 15% of a monolayer equivalent to about 200% of a monolayer equivalent. The distribution of sputtered primer metal upon substrate surfaces is believed to be somewhat nonuniform, however, such that deposition of a monolayer equivalent results in a discontinuous layer of primer metal. Lower average thicknesses of titanium are believed to form a discontinuous layer upon the polycarbonate substrate. Alternatively, at the lower average thickness of the range of sputtered titanium, the titanium may be described as "microislands" or "clusters" of primer material deposited upon the polycarbonate substrate. At the higher end of the average thickness range of deposited titanium priming metal, the layer is believed to become substantially continuous upon the surface of the substrate although the priming metal layer may be somewhat uneven or rough and demonstrate substantial variation in actual thickness.

The sputtering of the priming metal upon the polycarbonate substrate may be accomplished in a single pass by a sputtering unit or multiple passes by a sputtering unit. In one embodiment, the sputtering was accomplished by taping polycarbonate film samples on a carrier web and moving the carrier web past the sputter device. Alternatively the polycarbonate article may itself form a continuous web which can be wound from a feed roll to a take up roll past the sputtering unit.

The process described above may form a portion of a larger process for forming a reflector. In order to form a reflector, first a polycarbonate substrate or article is provided, second a primer metal is sputtered upon the surface of the polycarbonate, and third a layer of a reflective metal is deposited upon the primed surface of the polycarbonate.

Polycarbonate articles may be fabricated by a variety of well known means. The type of polycarbonate resin to be employed depends upon the fabrication step employed in providing the polycarbonate article. For example, injection grade polycarbonate resins such as, for example, Mobay PC available from Mobay Corporation (Bayer U.S.A. Inc.), are generally composed of lower molecular weight linear polymers and are generally self-releasing from injection mold surface. By comparison, extrusion grade polycarbonate resins such as, for example, General Electric 123R112, a Lexan brand resin with a melt flow rate of about 16g/10 minutes (ASTM D1238; 300/1.2), available from General Electric Company, Pittsfield, Massachusetts 01201 and Mobay CD2000 with a melt flow rate of 44g/10 min. are generally composed of higher molecular weight linear polymers and additionally include mold release agents to avoid sticking of the resin to surfaces during fabrication of the polycarbonate article. Other suitable polycarbonate resins include Mobay 2407 with melt flow rate (mfr) of about 15g/10 min., 2507, 2607 (mfr = about 11g/10 min), LQ2847 (mfr = about 11g/10 min.), LQ3147 (mfr = about 6g/10 min.), LTG3123 (mfr = about 6g/10 min.) and AL2647 (mfr = about 10g/10 min.. A preferred polycarbonate article is fabricated as a film including one structured face or surface. By "structured face" is generally meant a non-planar surface structure such as a Fresnel-type lens surface. The structured face is primed by the above-described process. The most preferred polycarbonate article is a film incorporating one optically structured face of a Fresnel-type structure which is sputter primed by the above-described sputtering process and subsequently vacuum-evaporative coated with a reflector metal.

The preferred reflector metal is aluminum. Aluminum may be applied by vacuum-evaporative deposition at thicknesses ranging from about 27 to about 320 nm, although any thickness which is reflective should function adequately. Pressures during the evaporative coating step of the process may be any pressure effective to deposit a coating, however, pressures from about $2 \times 10^{-5}$ to about $4 \times 10^{-4}$ torr are preferred. Alternative reflector metals which could be expected to be deposited by evaporative coating and function adequately are silver, gold, rhodium, irriduim, platinum, palladium, titantium and similar metals.

Additionally, an adhesive layer may be applied over the reflective metal layer. The adhesive layer is useful for application of the reflector to a support surface. Suitable adhesives include acrylic based adhesives such as 3M No. 467 and 468 available from Minnesota Mining and Manufacturing, St. Paul, Minnesota 55144. No. 467 and No. 468 are acrylic laminating adhesives with kraft glassine liners. No. 468 has an adhesive layer about 0.127 nm thick and is designed for rough surfaces. In an ASTM D903 peel test, No. 468 adhesive typically adheres polyester to stainless steel with a strength of 89 N/100mm.

In FIG. 1 a schematic cross-sectional view of a portion of a reflector of this invention is shown generally at 10. The reflector 10 includes a polycarbonate film or substrate 12 having a first surface 14 and a second surface 16. The second surface 16 includes an optical structure formed of a plurality of angled faces represented in FIG. 1 as active faces 18 and step faces 20. Together the active faces 18 and step faces 20 form a portion of a concentric Fresnel-type structure. Alternatively, linear optical structures as well as many other structures may be present on the surface 16.

A thin layer of sputtered primer material 22, preferably titanium, contacts the second surface 16 and promotes adhesion of a reflective metal layer 24 to the primed polycarbonate film. Preferably, the reflective metal layer 24 is formed by an evaporative coating of aluminum. An adhesive layer 26 contacts the reflective metal layer 24. The adhesive layer 26 serve two purposes in that it protects the reflective metal layer 24 from chemical degradation by the environment and enables mounting of the reflector 10 upon a support surface 28.

The preferred embodiment is useful as a back surfaced reflector. Light entering the reflector 10 at the first surface 14 is transmitted through the polycarbonate substrate or film 12 and is reflected from the optically-structured faces 18 and 20 of the second surface 16. The effective reflection of light is generally due to the reflective metal layer 24. The reflected light is then transmitted back through the polycarbonate layer 12 and exits the reflector 10 at the first surface 14. The reflected light thus is directed in a desired angle by the reflector 10.

In an alternative embodiment, the reflector may be a front surfaced reflector. The optional adhesive layer might be applied to the surface of the reflector opposite the reflective metal layer. The reflector might then be mounted such that the reflective metal layer, adhering to the primed optically-structured surface is separated from the adhesive layer by the polycarbonate film substrate.

## EXAMPLE 1

A film of polycarbonate was fabricated with a Fresnel-type optical structure on one surface. The resin employed in fabrication was GE123R112. The structured surface was sputter primed with titanium in an argon atmosphere at 4.0 microns of pressure with an Airco Model HRC-373 (Airco Temescal, Berkeley, California 94710). The sputter voltage was 470 volts.

An aluminum evaporative coating was subsequently applied to the primed surface. The aluminum coating was applied at thicknesses estimated at about 300 nm, 100 nm, and 30 nm.

Subsequently, the adhesion of the reflective metal to unprimed or sputter primed surfaces of polycarbonate substrates was measured in a peel test as follows Approximately 10.2 cms of a strip (about 12.7 cm by about 1.9 cm) of very agressive adhesive tape, Scotch Brand No. 250 Flatback Masking Tape (3M Company, St. Paul, Minnesota), was applied to the reflective coating and firmly pressed in place by rubbing back and forth twice with a finger. The tape was briskly pulled off the coating by pulling the unapplied portion of the strip (about 2.5 cm) perpendicular to the surface. A portion of the tested area, about 7.6 cm by about 1.9 cm, was examined and the percentage of the portion retaining the reflective coating estimated. Adequate adherence of the reflective coating to the substrate was defined as at least 90% of the coating remaining on the substrate. Less than 90% was considered inadequate (FAIL). Scotch Brand No. 250 tape has an adhesion of roughly 60 oz/in. width (66N/100 mm). The product of Example 1 demonstrated adequate (OK) adhesion. The three thicknesses of aluminum coating performed equivalently in the peel test. Further, the vapor coat adhesion appeared to be roughly 98-100% after the peel test. Additional peel testing with 3M No. 468 MS adhesive, a more agressive adhesive than No. 250 showed adherence strengths of about 8.75 to about 9.80 lbs/inch.

EXAMPLES 2-29

The process of Example 1 was repeated with variations in resin, primer metal, primer metal thickness, gas, pressure, power or voltages as indicated in Table 1 for Examples 2-29. Peel test results for aluminum coated products of these examples are also indicated in Table 1. The various thicknesses of primer metal performed equivalently in the peel test.

COMPARATIVE EXAMPLES 30-32

By way of comparison, fabricated films of GE123R112 polycarbonate resin (Example 30) and CD2000 polycarbonate resin (Example 31) were evaporative aluminum coated and tested for adhesion, without the benefit of sputter priming. Both showed extremely poor adhesion. Another polycarbonate resin, Mobay PC, was molded into a sheet and aluminum coated in Example 32. Mobay PC is believed to be free of release agents, unlike GE123R112 and CD2000. The Mobay PC substrate of Example 32 demonstrated adequate reflective coating adhesion without the benefit of sputter priming.

It is believed that the improved adhesion resulting from a sputter priming of polycarbonate surfaces could be optimized, if desired, for a particular type of polycarbonate surface by employing a modified tensile pull strength test which would allow more accurate determinations of adhesion.

Example 30 was also compared to Example 1 in a salt spray test and failed (lost reflective aluminum) more rapidly than the sputter primed reflector of Example 1.

While not wishing to be bound by theory, we believe that sputter priming is particularly useful in priming polycarbonate substrate surfaces which include release agents. The invention allows fabrication of structured substrate surfaces (which benefit from the presence of release agents) and subsequent deposition of evaporative reflective coatings which are strongly adherent.

5

TABLE I

| Example | Substrate Resin | Primer Metal | Sputter Gas | Pressure -3 (10 Torr) | Voltage | Power (Watts) | Estimated Primer Thickness (nm) | Peel Test |
|---|---|---|---|---|---|---|---|---|
| 1 | GE123R112 | Ti | Ar | 4.0 | 470 | 500 | 5.0 | OK |
| 2 | GE123R112 | Ti | Ar | 4.0 | 450 | 380 | 3.8 | OK |
| 3 | GE123R112 | Ti | Ar | 4.0 | 445 | 330 | 3.3 | OK |
| 4 | GE123R112 | Ti | Ar | 4.0 | 440 | 300 | 3.0 | OK |
| 5 | GE123R112 | Ti | $O_2$ | 4.0 | 365 | 100 | 1.0 | OK |
| 6 | GE123R112 | Ti | $O_2$ | 4.0 | 385 | 200 | 2.0 | OK |
| 7 | GE123R112 | Ti | $O_2$ | 4.0 | 411 | 400 | 4.0 | OK |
| 8 | GE123R112 | Ti | $O_2$ | 4.0 | * | 800 | 8.0 | OK |
| 9 | GE123R112 | Cu | Ar | 4.0 | 427 | 260 | 5.2 | FAIL |
| 10 | GE123R112 | Cu | Ar | 4.0 | 377 | 100 | 2.0 | FAIL |
| 11 | GE123R112 | Cu | Ar | 4.0 | 313 | 20 | 0.4 | FAIL |
| 12 | GE123R112 | Cu | Ar | 4.0 | 300 | 10 | 0.2 | FAIL |
| 13 | GE123R112 | Cu | $O_2$ | 4.0 | 287 | 100 | 2.0 | OK |
| 14 | GE123R112 | Cu | $O_2$ | 4.0 | 313 | 200 | 4.0 | OK |
| 15 | GE123R112 | Cu | $O_2$ | 4.0 | 336 | 400 | 8.0 | OK |
| 16 | GE123R112 | Cu | $O_2$ | 4.0 | 353 | 800 | 16.0 | OK |
| 17 | GE123R112 | Ti | $O_2$ | 4.3 | * | 700 | 7.0 | OK |

* = data not available

## TABLE I (Continued)

| Example | Substrate Resin | Primer Metal | Sputter Gas | Pressure (10^-3 Torr) | Voltage | Power (Watts) | Estimated Primer Thickness (nm) | Peel Test |
|---|---|---|---|---|---|---|---|---|
| 18 | GE123R112 | Ti | $O_2$ | 4.3 | * | 300 | 3.0 | OK |
| 19 | GE123R112 | Ti | $O_2$ | 4.3 | * | 100 | 1.0 | OK |
| 20 | GE123R112 | Ti | Air | 4.3 | * | 700 | 7.0 | OK |
| 21 | GE123R112 | Ti | Air | 4.3 | * | 100 | 1.0 | OK |
| 22 | GE123R112 | Ti | Air | 4.3 | * | 300 | 3.0 | OK |
| 23 | GE123R112 | Ti | Air | 4.3 | * | 50 | 0.5 | OK |
| 24 | CD2000 | Ti | $O_2$ | 2.7 | 419 | 300 | 3.0 | OK |
| 25 | CD2000 | Ti | $O_2$ | 2.7 | 379 | 100 | 1.0 | OK |
| 26 | CD2000 | Ti | $O_2$ | 2.7 | 360 | 50 | 0.5 | OK |
| 27 | CD2000 | Ti | Air | 2.7 | 440 | 300 | 3.0 | OK |
| 28 | CD2000 | Ti | Air | 2.7 | 398 | 100 | 1.0 | OK |
| 29 | CD2000 | Ti | Air | 2.7 | 376 | 50 | 0.5 | OK |
| Comparative Examples | | | | | | | | |
| 30 | GE123R112 | — | — | — | — | — | — | FAIL |
| 31 | CD2000 | — | — | — | — | — | — | FAIL |
| 32 | Mobay PC | — | — | — | — | — | — | OK |

* = data not available

Although the present invention has been described with reference to preferred embodiments, workers skilled in the art will recognize that changes may be made in form and detail without departing from the spirit and scope of the invention.

## Claims

1. A process for treating the surface of a polycarbonate substrate to increase adherence of a subsequently applied reflective metal layer, said process further characterized in that it comprises sputtering a primer metal or primer metal-containing compound upon said surface.

2. A process for forming a reflector characterized in that said process comprises:

1) providing a polycarbonate article;

2) sputtering a primer metal or primer metal-containing compound upon a surface of the polycarbonate article; and then

3) depositing a layer of reflective metal upon the sputtered surface.

3. The process of claim 2 further characterized in that said reflective metal is aluminum.

4. The process of claim 2 further characterized in that said process further comprises the step of applying an adhesive layer upon the layer of reflective metal.

5. The process of any one of claims 1-4 further characterized in that said polycarbonate substrate or article includes a release agent.

6. The process of any one of claims 1-5 further characterized in that said primer metal is chosen from the group consisting of titanium, copper, and chromium.

7. The process of any one of claims 1-6 further characterized in at least one of the following:

1) the average thickness of primer metal sputtered upon the surface is from about 0.5 to about 7 nanometers; or

2) the sputtering voltage is from about 360 to about 470 volts and the sputtering pressure is from about $2 \times 10^{-3}$ to about $4 \times 10^{-3}$ torr.

8. The process of any one of claims 1-7 further characterized in at least one of the following:

1) said primer metal is titanium and said sputtering is performed in an atmosphere including an inert gas, oxygen, or nitrogen; or

2) said primer metal is copper and said sputtering is performed in an atmosphere of oxygen.

9. An article characterized in that said article comprises a polycarbonate substrate having a surface, having a primer metal sputtered upon the surface.

10. The article of claim 9 further characterized in that said article is a Fresnel-type lens and the primer metal is applied to the structured face of the lens.

11. The article of any one of claims 9 or 10 further characterized in that said article further comprises a layer of reflective metal overlying the sputtered primer metal.

12. The article of claim 11 further characterized in at least one of the following:

1) the polycarbonate substrate, the sputtered primer metal, and the layer of reflective metal have an adhesion strength of at least about 66 Newtons/100 millimeters; or

2) said article further comprises an adhesive layer upon the layer of reflective metal.

13. The article of any one of claims 9-12 further characterized in that the primer metal is chosen from the group consisting of titanium, copper, and chromium.

14. The article of any one of claims 9-13 further characterized in that said article includes a release agent.

FIG.1